# EUROPEAN PATENT APPLICATION

(11) **EP 4 502 007 A1**
(43) Date of publication of application: **05.02.2025**
(21) Application number: 24172711.4
(22) Date of filing: 26.04.2024
(51) Int. Cl.: C08G 65/48

(54) **MODIFIED POLYPHENYLENE ETHER RESIN, PREPARATION METHOD THEREOF, AND RESIN COMPOSITION INCLUDING THEREOF**

(30) Priority: 31.07.2023 TW 112128709
(71) Applicant: NAN YA PLASTICS CORPORATION, Taipei City 114030 (TW)
(72) Inventor: LEE, Cheng-Chung, 114030 Taipei City (TW); WU, Chen Hua, 114030 Taipei City (TW); CHANG, Jung Kai, 114030 Taipei City (TW); TSAI, Yun-Chia, 114030 Taipei City (TW); HSU, Hung-Wen, 114030 Taipei City (TW)
(74) Representative: Becker, Eberhard

(57) **Abstract**

A modified polyphenylene ether resin having a structure represented by [Formula 1] is provided.

## Description

### BACKGROUND

### Technical Field

The disclosure relates to a modified resin and preparation method thereof, and more particularly, to a modified polyphenylene ether resin and preparation method thereof.

### Description of Related Art

With the widespread adoption of the 5th generation mobile networks (5G), the printed circuit board (PCB) industry is undergoing a transition towards higher speeds and frequencies. This, in turn, is driving the continuous development and improvement of copper clad laminate (CCL) materials. copper clad laminates are usually composed of copper foil, glass fiber cloth, and resin, with polyphenylene ether resin being a commonly used insulating material. However, industrial-grade polyphenylene ether may possess larger molecular weights and higher viscosities, potentially leading to lower quality and/or production rates of manufactured copper clad laminates. Moreover, adapting the corresponding specifications to meet diverse requirements can be challenging. Thus, the modification of the polyphenylene ether resin (e.g., terminal functional group modifications, adjustments to molecular weight and distribution) to facilitate easier copper clad laminate production and to maintain good quality in the resulting product is currently a significant research endeavor in the field.

### SUMMARY

The disclosure provides a modified polyphenylene ether resin and preparation method thereof, as well as a resin composition including the modified polyphenylene ether resin.

The preparation method of the modified polyphenylene ether resin of the disclosure is described below. An unmodified polyphenylene ether is provided. The unmodified polyphenylene ether is reacted with a phenolic compound and a radical initiator to obtain a corresponding product. Alkaline washing and solvent recrystallization are carried out on the product to obtain the modified polyphenylene ether resin.

The modified polyphenylene ether resin of the disclosure has a structure represented by [Formula 1] in the specification.

The resin composition of the disclosure includes the aforementioned modified polyphenylene ether resin.

The electronic component of the disclosure includes a film layer formed from the aforementioned resin composition.

Based on the above, the modified polyphenylene ether resin of the disclosure may be relatively simple in preparation, and may be applied to electronic components or electronic products (e.g., circuit board or copper clad laminates).

### BRIEF DESCRIPTION OF THE DRAWINGS

FIGURE is a schematic flowchart of the preparation method of the modified polyphenylene ether resin according to one embodiment of the disclosure.

### DESCRIPTION OF THE EMBODIMENTS

In the following detailed description, for purposes of illustration and not limitation, exemplary embodiments disclosing specific details are set forth in order to provide a thorough understanding of the various principles of the disclosure. However, those skilled in the art will readily recognize that, with the benefit of the disclosure provided herein, the invention may be implemented in other embodiments that deviate from the specific details disclosed herein. In addition, the description of well-known apparatus, method, and material may be omitted so as not to obscure the description of the various principles of the disclosure.

The range as expressed herein can be understood as "approximately" from a specific value to "approximately" another specific value, which can also be directly indicated as a specific value and/or up to another specific value. When expressing the range, another embodiment includes from that specific value and/or up to another specific value. Similarly, when values are expressed as approximate values by using the precursor "about", it will be understood that such specific values form another embodiment. For example, when expressing a value using the precursor "about", it can be directly indicated as that specific value. Furthermore, when expressing the value using the precursor "about", it can be within a range of ±3% of that value; furthermore, within a range of ±1% of that value. It will be further understood that each endpoint of a range is evidently related to or unrelated to another endpoint.

Herein, non-limiting terms (e.g., "may", "can", "for example", or other similar terms) are used to indicate non-essential or optional implementations, inclusions, additions, or presences.

Herein, derivatives of a compound may involve substitution of a non-reactive hydrogen atom in the compound with an isotope or with a non-reactive alkyl group containing one to five carbons (referred to as C1 to C5).

Unless otherwise defined, all terms (including technical and scientific terms) used herein have the same meaning as commonly understood by one of ordinary skill in the art to which this disclosure belongs. It should be further understood that terms (such as those defined in commonly used dictionaries) should be construed as having meanings consistent with their meanings in the context of the related art, and are not to be construed as idealized or excessive formal meaning, unless expressly defined as such herein.

Referring to FIGURE, the preparation method of the modified polyphenylene ether resin may include the following steps. Step S10: Provide an unmodified polyphenylene ether. Step S20: React the polyphenylene ether with a phenolic compound and a radical initiator for modification. Step S30: Purify the product of the reaction by alkaline washing and solvent recrystallization. Step S40: Obtain a modified polyphenylene ether.

### <Modification of the polyphenylene ether resin>

In one embodiment, a corresponding product may be obtained or produced by reacting the unmodified polyphenylene ether, the phenolic compound, and the radical initiator appropriately, so as to carry out the corresponding modification.

In one embodiment, the unmodified polyphenylene ether may be a polyphenylene ether that is substituted with only hydrogen on the corresponding phenyl group or an alkyl group with one to five carbons (referred to as C1 to C5). For example, the unmodified polyphenylene ether may be poly(2,6-dimethyl-1,4-phenylene ether) (CAS No.: 25134-01-4), but the disclosure is not limited thereto.

In one embodiment, the phenolic compound includes, for example, bisphenol compounds. In one embodiment, the bisphenol compounds include, for example, bisphenol A (BPA), tetramethyl bisphenol (TMBP), tetramethyl bisphenol A (TMBPA), tetramethyl bisphenol F (TMBPF), bisphenol S (BPS), dicyclopentadiene bisphenol (e.g., DCPD-DIDMP, 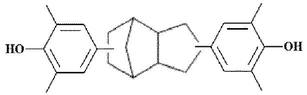 ) or derivatives thereof.

In one embodiment, the phenolic compound includes, for example, a tetraphenolic compounds. In one embodiment, the tetraphenolic compounds include, for example, 1,1,2,2-tetrakis(p-hydroxyphenyl)ethane (TPE, CAS number: 7727-33-5) or derivatives thereof.

In one embodiment, the radical initiator includes, for example, peroxides; and preferably, the radical initiator may be peroxides with a corresponding benzene ring. In one embodiment, the radical initiator may include benzoyl peroxide (BPO) or derivatives thereof (e.g., benzoyl peroxide with alkyl substitution). The "alkyl substitution" mentioned above or below may be the alkyl substitution where at least one hydrogen is replaced with an alkyl group containing one to five carbons (referred to as C1 to C5).

In one embodiment, the reaction carried out with the unmodified polyphenylene ether, the phenolic compound, and the radical initiator as the product may be similar to the rearrangement reaction. The reaction mechanism may involve the radical initiator forming radicals in an appropriate manner (e.g., heating). Then, the radicals may attack the terminals of the phenolic compound, resulting in corresponding radicals; and/or, the radicals may attack the terminals of the polyphenylene ether, forming corresponding radicals. Between the polyphenylene ether with terminal radicals and the phenolic compound with terminal radicals, the reaction may terminate by the mutual reaction/combination of the radicals thereof, resulting in the formation of corresponding molecules/polymers with at least two hydroxyl groups. In addition, the aforementioned radicals may also react with the benzene ring of the polyphenylene ether and/or the structure thereon, which may reduce the chain length of the polyphenylene ether and correspondingly reduce the molecular weight of the polyphenylene ether. Thus, in the aforementioned reaction, the relationship between the polyphenylene ether and the radical initiator may be related to the molecular weight or the polydispersity index (PDI) of the product. For example, when the ratio of the radical initiator is higher (e.g., higher mole quantity), the molecular weight of the product may be lower, and/or the polydispersity index may be higher. Conversely, when the ratio of the radical initiator is lower (e.g., lower mole quantity), the molecular weight of the product may be higher, and/or the polydispersity index may be lower. The polydispersity index is also called the molecular weight distribution, which refers to the ratio of the weight average molecular weight to the number average molecular weight (i.e., Mw/Mn).

In one embodiment, an equivalent weight of the radical initiator is approximately 0.05 times to about 2 times a phenolic equivalent weight of the phenolic compound. That is, the phenolic equivalent weight of the phenolic compound: the equivalent weight of radical initiator ≒ 100: 5 to 100:200. In this way, the average number of hydroxyl groups per modified polyphenylene ether molecule in the modified polyphenylene ether obtained after the reaction is about 2.0 or more.

In one embodiment, preferably, the equivalent weight of the radical initiator is about 0.1 times to about 1.5 times the phenolic equivalent weight of the phenolic compound. That is, the phenolic equivalent weight of the phenolic compound: the equivalent weight of radical initiator ≒ 100: 10 to 100:150.

In one embodiment, preferably, the equivalent weight of the radical initiator may be less than the phenolic equivalent weight of the phenolic compound. In this way, the possibility of side reactions may be reduced (however, under the natural conditions of chemical reactions, it does not refer to being totally avoided).

In one embodiment, more preferably, the phenolic equivalent weight of the phenolic compound is about 1.5 times to about 20 times the equivalent weight of the radical initiator. In one embodiment, more preferably, the phenolic equivalent weight of the phenolic compound is more than 1.5 times (e.g., about 1.75 times, about 1.8, times, or about 2 times) to about 10 times the equivalent weight of the radical initiator.

In one embodiment, a catalyst may be further added (but not limited thereto). The catalyst may increase the reaction rate of the rearrangement reaction. The catalyst may be added together with the phenolic compound. The catalyst may include water-soluble catalysts, such as tertiary amines, quaternary ammonium salts, phosphor salts, or combinations thereof, suitable for dissolution in water. For example, the catalyst may include tetraalkyl ammonium halides (e.g., tetramethyl ammonium chloride, TMAC, CAS number: 75-57-0), tetraethyl ammonium chloride (TEAC, CAS number: 56-34-8), tetramethyl ammonium bromide (TMAB, CAS number: 64-20-0), tetraethyl ammonium bromide (TEAB, CAS number: 71-91-0), tetrapropyl ammonium bromide (TPAB, CAS number: 1941-30-6), tetrabutyl ammonium bromide (TBAB, CAS number: 1643-19-2), benzylalkylammonium halides (e.g., benzyltrimethylammonium chloride (BTMAC, CAS number: 56-93-9)), benzyltriethylammonium chloride (BTEAC, CAS number: 56-37-1), or benzyldimethyldecylammonium chloride (CAS number: 965-32-2). In one embodiment, based on the unmodified polyphenylene ether used in the reaction, the added weight of the catalyst may be about 1 wt% or less of the weight of the unmodified polyphenylene ether used in the reaction.

In one embodiment, the average number of hydroxyl groups per modified polyphenylene ether molecule may be estimated by dividing the total mole quantity of the hydroxyl groups by the total mole quantity of the modified polyphenylene ether molecule (i.e., the total mole quantity of the hydroxyl groups ÷ the total mole quantity of the modified polyphenylene ether molecule). The total mole quantity of the hydroxyl groups may be determined by commonly used standards (e.g., ISO 4629-2:2016, ASTM D1959, GB/T 12008.3, and CNS 6681, but not limited thereto) for hydroxyl value standardization. The total mole quantity of the polymer molecule may be converted by measuring the corresponding average molecular weight using a gel permeation chromatography (GPC).

In one embodiment, the aforementioned modification reaction may be carried out in a hydrophobic solvent or a lipophilic solvent. In one embodiment, the modification reaction may be carried out in toluene, xylene, or the co-solvent of the foregoing.

In one embodiment, the aforementioned modification reaction may be carried out in an environment greater than room temperature (e.g., greater than 25°C). In one embodiment, the reaction may be carried out in an environment of greater than or equal to about 80°C.

In one embodiment, the aforementioned modification reaction may be carried out in an environment lower than the boiling point temperature of the corresponding solvent.

In one embodiment, the aforementioned modification reaction may be carried out for about 0.5 hours to 6 hours. In one embodiment, the aforementioned modification reaction may be carried out for about 1 hours to 5 hours. In one embodiment, the aforementioned modification reaction may be carried out for about 2 hours to 4 hours. In one embodiment, the aforementioned modification reaction may be carried out for about 3 hours.

In one embodiment, the modified polyphenylene ether after the reaction may further undergo alkaline washing. In this way, the phenolic equivalent weight of the modified polyphenylene ether may be increased. In one embodiment, after the reacted modified polyphenylene ether undergo alkaline washing, the average number of hydroxyl groups per modified polyphenylene ether molecule may be greater than 2.2.

In one embodiment, the aforementioned alkaline washing may be carried out with corresponding alkaline solution. In one embodiment, the alkaline solution may include a solution containing alkali metal ions or alkaline earth metal ions, preferably a solution containing alkali metal ions. Cations with a valence greater than or equal to +3 may cause unwanted side reactions. For example, the alkaline solution may include sodium hydroxide, potassium hydroxide, sodium bicarbonate, potassium bicarbonate, sodium carbonate, potassium carbonate, sodium alkoxide (e.g., sodium methoxide (MeONa), sodium ethoxide (EtONa), sodium propoxide, sodium butoxide), potassium alkoxide (e.g., potassium methoxide (MeOK), potassium ethoxide (EtOK), potassium propoxide, potassium butoxide), or mixtures of the foregoing, which are soluble in suitable solvents (e.g., water, alcohols, alcohol-water mixtures).

In one embodiment, the alkali equivalent weight of the alkaline solution used for alkaline washing may be equivalent to about 10 wt% to about 60 wt% sodium hydroxide aqueous solution.

In one embodiment, the aforementioned alkaline washing process may be carried out in an environment greater than room temperature (e.g., greater than 25°C). In one embodiment, the reaction may be carried out in an environment of greater than or equal to about 40°C.

In one embodiment, the aforementioned alkaline washing process may be carried out in an environment lower than the boiling point temperature of the corresponding solvent.

In one embodiment, the aforementioned alkaline washing process may be carried out for about 0.5 hours to 4 hours. In one embodiment, the aforementioned modification reaction may be carried out for about 0.5 hours to 3 hours. In one embodiment, the aforementioned modification reaction may be carried out for about 1 hours to 2 hours.

In one embodiment, after the aforementioned modified polyphenylene ether molecule is formed, unreacted or non-reactive large molecule polyphenylene ether may be removed by solvent purification and/or recrystallization. For example, compared to the modified polyphenylene ether molecule with a molecular weight of about 20,000 mole/g, unreacted or non-reactive large molecule polyphenylene ether with a molecular weight above 40,000 may have low solubility in some low polarity solvents (e.g., tetrahydrofuran, methyl ethyl ketone, methyl isobutyl ketone, cyclohexanone). Thus, the unreacted or non-reactive large molecule polyphenylene ether may be precipitated and removed by adding the aforementioned low polarity solvent. In addition, corresponding high polarity solvents (e.g., methanol, ethanol, or isopropanol) may be added to recrystallize the modified polyphenylene ether. In this way, the purity and/or quality of the modified polyphenylene ether may be improved.

In one embodiment, the modified polyphenylene ether with a number average molecular weight (Mn) of about 500 g/mol to 4,000 g/mol may be obtained by the aforementioned solvent purification method and recrystallization, and the polydispersity index (PDI) of the modified polyphenylene ether is less than or equal to about 2.5.

In one embodiment, preferably, the modified polyphenylene ether with a number average molecular weight (Mn) of about 1,000 g/mol to 3,000 g/mol may be obtained by the aforementioned solvent purification method and recrystallization, and the polydispersity index (PDI) of the modified polyphenylene ether is less than or equal to about 1.8.

In one embodiment, the solvent used in recrystallization may include toluene, xylene, tetrahydrofuran (THF), methyl ethyl ketone (MEK), cyclohexanone, methyl isobutyl ketone (MIBK), or the co-solvents of the foregoing.

In one embodiment, the modified polyphenylene ether may be represented by the following [Formula 1].

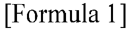

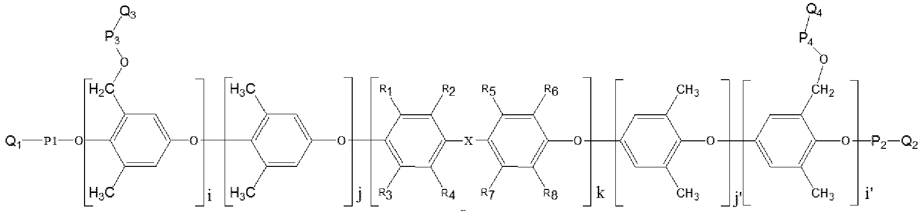

In [Formula 1], k is an integer greater than or equal to 0; i, i', j, and j' may be identical or different from each other; i and j may be integers from 0 to 200, respectively; and i' and j' may be integers from 1 to 200, respectively. In addition, a value of i+i'+j+j'+k is between 2 and 400.

In [Formula 1], preferably, k is 0 or 1; i, i', j, and j' may be identical or different from each other and may be integers from 1 to 200, respectively. In addition, a value of i+i'+j+j'+k is between 4 and 200.

In [Formula 1], Ri to R₈ may be identical or different from each other, and may be respectively selected from a hydrogen group or an alkyl group having one to six carbons (referred to as C1 to C6).

In [Formula 1], P₁ to P₄ may be identical or different from each other, and may be respectively selected from a single bond (-) or a ketone group ( 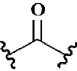 ).

In [Formula 1], Q₁ to Q₄ may be identical or different from each other, and may be respectively selected from a benzene ring group, a styryl group, a phenylethynyl group, a ethynyl group, a vinyl group, a methyl vinyl group, a naphthalene ring group, or hydrogen.

In [Formula 1], X may be selected from a single bond (-) of the following linking groups

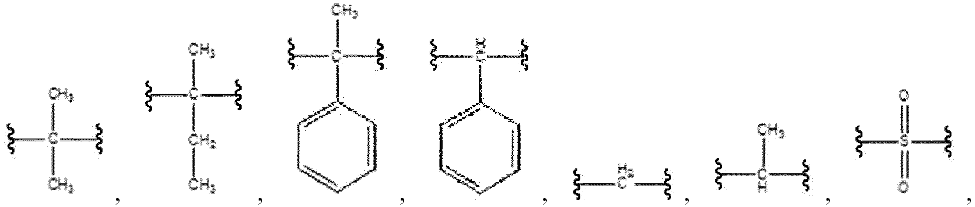

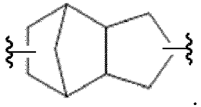

In one embodiment, after the aforementioned solvent purification and recrystallization, based on the total weight of the product after drying, the proportion of the large molecule polyphenylene ether with a molecular weight above 20,000 g/mole may basically be below 1.5 wt%, preferably about 1.0 wt% or less.

In one embodiment, the number average molecular weight (Mn) of the modified polyphenylene ether resin may be about 500 g/mol to 4,000 g/mol, preferably about 1,000 g/mol to 3,000 g/mol.

In one embodiment, the polydispersity index of the modified polyphenylene ether resin is less than or equal to about 2.5, preferably less than or equal to about 1.8.

In one embodiment, the hydroxyl equivalent weight of the modified polyphenylene ether resin is less than or equal to about 1,300 g/eq, and the corresponding number of hydroxyl groups per molecule is about 2.0 to 4.0.

### <Application of modified polyphenylene ether resin>

The modified polyphenylene ether resin represented by [Formula 1] is suitable for the application in electronic products.

Since the modified polyphenylene ether resin represented by [Formula 1] may have lower dielectric properties, a higher glass transition temperature (Tg), better heat resistance, and/or better fluidity, it is suitable for the application in electronic products.

Since the modified polyphenylene ether resin represented by [Formula 1] may be easily dissolved in common organic solvents (e.g., toluene or methyl ethyl ketone (MEK)), it is more convenient to use.

In one embodiment, the modified polyphenylene ether resin represented by [Formula 1] applied in electronic products exhibits better heat resistance, a higher glass transition temperature, and/or better fluidity when compared to other known resins that are used in electronic products.

In one embodiment, the modified polyphenylene ether resin represented by [Formula 1] applied in electronic products may exhibit better heat resistance, a higher glass transition temperature, and better fluidity when compared to other known resins that are used in electronic products. In this way, its application (e.g., for the copper clad laminates) may be relatively simple.

In one embodiment, the resin composition may include the modified polyphenylene ether resin in the aforementioned embodiment. In one embodiment, with the total weight of the resin composition being 100 weight percent, the modified polyphenylene ether resin may range from 30 weight percent (wt%) to 60 wt%, preferably about 40 wt%.

In one embodiment, the resin composition may further include a cross-linking agent. In one embodiment, with the total weight of the resin composition being 100 wt%, the cross-linking agent may range from 10 wt% to 20 wt%, preferably about 15 wt%.

In one embodiment, the addition of the cross-linking agent may improve the degree of cross-linking between the resin and/or corresponding polymer. In one embodiment, the cross-linking agent may contain allyl group. In one embodiment, the cross-linking agent may include triallyl cyanurate (TAC), trially isocyanurate (TAIC), trimethallyl isocyanurate (TMAIC), diallyl phthalate, divinylbenzene, triallyl trimellitate, or combinations of the foregoing.

In one embodiment, the resin composition may include a filler. In one embodiment, with the total weight of the resin composition being 100 wt%, the filler may range from 5 wt% to 15 wt%, preferably about 10 wt%.

In one embodiment, the addition of an inorganic filler may improve the viscosity of the resin composition. For example, the inorganic filler may be: silicon dioxide, titanium dioxide, aluminum hydroxide, aluminum oxide, magnesium hydroxide, magnesium oxide, calcium carbonate, boron oxide, calcium oxide, strontium titanate, barium titanate, calcium titanate, magnesium titanate, boron nitride, aluminum nitride, silicon carbide, cerium oxide, or combinations of the foregoing.

In one embodiment, the silicon dioxide added as the inorganic filler may include fused or crystalline silicon dioxide. In one embodiment, if considering the dielectric properties when applied to the copper clad laminate, fused silicon dioxide is more preferred.

In one embodiment, the titanium dioxide added as the inorganic filler may include titanium dioxide in rutile, anatase, or brookite configurations. In one embodiment, if considering the dielectric properties when applied to the copper clad laminate, the titanium dioxide in rutile configuration is more preferred.

In one embodiment, the resin composition may further include a cross-linking promoter. In one embodiment, with the total weight of the resin composition being 100 wt%, the cross-linking promoter may range from 0.5 wt% to 1.5 wt%, preferably about 1.0 wt%.

In one embodiment, the cross-linking promoter may enhance the system reactivity. The promoter may include catalysts and peroxides.

In one embodiment, the catalyst as the cross-linking promoter may include 2-phenyl-1H-imidazole-1-propiononitrile (2PZCN; CAS number: 23996-12-5), 1-benzyl-2-phenyl-1H-imidazole (1B2PZ; CAS number: 37734-89-7), thiabendazole (TBZ; CAS number: 148-79-8), or combinations of the foregoing, but the disclosure is not limited thereto.

In one embodiment the peroxides as the cross-linking promoter may include tert-butyl cumyl peroxide, dicumyl peroxide (DCP), benzoyl peroxide (BPO), 2,5-dimethyl-2,5-di(tert-butylperoxy)hexane, 2,5-dimethyl-2,5-di(tert-butylperoxy)hexyne, 1,1-di-(tert-butylperoxy)-3,3,5-trimethylcyclohexane, di(tert-butylperoxyisopropyl)benzene, Luperox^{®}F series peroxide formulations (e.g., 1,3(4) -Bis(tert-butylperoxyisopropyl)benzene, 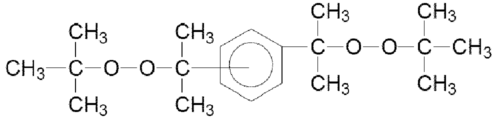 ,LuF), or the combinations of the foregoing, but the disclosure is not limited thereto.

In one embodiment, the resin composition may further include a flame retardant. In one embodiment, with the total weight of the resin composition being 100 wt%, the flame retardant may range from 5 wt% to 15 wt%, preferably about 10 wt%.

In one embodiment, the addition of the flame retardant may improve the flame resistance or flame retardancy of the resin composition. Herein, "flame resistance" or "flame retardancy" means that the referred object (e.g., a film, a layer, or a structure) may pass the flame retardancy standard of standard test method. For example, taking the UL94 flammability of plastic standard based on Test for Flammability of Plastic Materials for Parts in Devices and Appliances published by Underwriters Laboratories Inc. (UL) in the United States as an example, the standard requirement is at least an HB rating.

In one embodiment, the flame retardant may include brominated flame retardant, phosphorous flame retardant, or combinations of the foregoing, but the disclosure is not limited thereto.

In one embodiment, the brominated flame retardant include Saytex BT 93W (ethylene bistetrabromophthalimide) flame retardant, Saytex BT93, Saytex 120 (tetradecabromodiphenoxy benzene) flame retardant, Saytex 8010 (Ethane-1,2-bis(pentabromophenyl)) flame retardant, Saytex 102 (decabromo diphenoxy oxide) flame retardant, or combinations of the foregoing, produced by Albemarle Corporation (US Corporation).

In one embodiment, the phosphorous flame retardant may include sulphosuccinic acid ester, phosphazene, ammonium polyphosphate, melamine polyphosphate, melamine cyanurate, or combinations of the foregoing. For example, it may include triphenyl phosphate (TPP), resorcinol bis(diphenyl phosphate) (RDP), bisphenol A bis(diphenyl phosphate) (BPAPP), resorcinol bis(diphenyl phosphate) (e.g., CR-733S manufactured by Daihachi Chemical Industry Co., Ltd. in Japan), phosphoric acid 1,3-phenylene tetrakis(2,6-dimethylphenyl) ester (e.g., PX-200 manufactured by Daihachi Chemical Industry Co., Ltd. in Japan), SPB-100 phosphorous flame retardant manufactured by Otsuka Chemical Co., Ltd. in Japan, or combinations of the foregoing.

In one embodiment, the resin composition containing the modified polyphenylene ether resin in one embodiment of the disclosure may be used for the manufacture of electronic components (e.g., copper clad laminates or printed circuit boards, but not limited thereto).

In one embodiment, the resin composition containing the modified polyphenylene ether resin in one embodiment of the disclosure may be suitable for forming insulating films for electronic products, and its application in electronic products may have the following specifications: a dielectric constant (Dk) of less than or equal to about 4.0 (e.g., about 3.3 to 4.0); a dissipation factor (Df) of less than or equal to about 0.0050 (e.g., about 0.0035 to 0.0050); a glass transition temperature (Tg) of about 210°C to 235°C; a peeling intensity greater than about 6.0 lb/in (e.g., further greater than or equal to 6.5 lb/in); and/or a water absorption rate of less than or equal to about 0.5% (e.g., 2-hour water absorption rate of less than or equal to about 0.5%).

Most of the commercially available resins for copper clad laminate manufacturing (e.g., SA-9000 resin manufactured by Sabic Corporation, but not limited to) are prepared by oxidative polymerization. However, the aforementioned oxidative polymerization method requires the introduction of oxygen. During the process of introducing oxygen, it is necessary to control the flow rate, velocity, and/or concentration of oxygen to prevent the possibility of intense oxidizing reaction (e.g., combustion, flashover, or explosion) due to the coexistence of solvents and oxygen. Furthermore, a reaction tank suitable for the aforementioned oxidative polymerization must be equipped with gas detectors, fire prevention equipment, and/or explosion prevention devices, leading to higher production costs accordingly. In addition, the oxidative polymerization method often requires the addition of a metal catalyst (mostly metals with a valence of +3 or higher or transition metals). The separation of the metal catalyst from the product usually necessitates purification, making the corresponding reaction steps more complicated. Moreover, the oxidative polymerization method frequently needs to be carried out in specific environments (e.g., specific solvents), making it less amenable to customized modifications. Based on the above, compared to commercially available resins used in copper clad laminate manufacturing, the modified polyphenylene ether resin in one embodiment of the disclosure offers a simpler preparation process. Furthermore, the modified polyphenylene ether resin in one embodiment of the disclosure is suitable for the manufacturing of copper clad laminates, and/or the copper clad laminates manufactured by adopting the same meets common specifications.

### <Manufacturing of copper clad laminate>

The aforementioned modified polyphenylene ether resin of the aforementioned embodiment may be dissolved and mixed with other components in a suitable solvent to form a resin varnish, which may be utilized to prepare copper clad laminates using known methods. For instance, the resin composition of the aforementioned embodiment may be dissolved in a suitable solvent to form a resin varnish, which may be utilized in the manufacturing of the copper clad laminates.

A manufacturing method for a copper clad laminate may proceed as follows.

The 2116 fiberglass cloth is impregnated with the aforementioned resin varnish and then dried for several minutes under conditions of about 170°C (including impregnation machine temperature). By adjusting and controlling the drying time, the post-drying prepreg is obtained with a melting viscosity between about 4,000 and 12,000 poises. Next, four prepregs are stacked layer by layer between two copper foils with a thickness of about 35 µm and subjected to a lamination process (as detailed below) to form a copper clad laminate in one embodiment.

The conditions/procedures of the lamination process are outlined as follows:
Step 1: The temperature is raised from about 80°C to about 195°C over a period of about 0.5 hours (referred to as 85 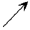 195°C, 0.5hr).
Step 2: The pressure is increased from about 7 kg/cm² to about 25 kg/cm² over a period of about 0.5 hours (referred to as 7 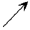 25 kg/cm², 0.5hr).
Step 3: Lamination is carried out for about 2.0 hours at a temperature of about 195°C and a pressure of about 25 kg/cm² (referred to as 195°C / 25 kg/cm², 2.0hr).

### <Example and Comparative example>

Examples and comparative examples are shown below, and the disclosure will be specifically described, but the disclosure is not limited to the following examples at all. It is worth noting that, for the sake of conciseness, certain numerical values in the examples or comparative examples (such as those recorded in tables) may have been presented without the qualifier "about." Moreover, each value may include the value and the average value within a range of acceptable deviations from a particular value determined by a person skilled in the art, having a range of ±3% of that value, taking into account the particular amount of measurement and measurement-related error in question (i.e., the limitations of the measurement system); and further, a range of ±1% of that value.

### <Preparation example and corresponding comparative example of modified polyphenylene ether resin>

### <Example 1>

About 600 grams of toluene, about 100 grams of commercially available polyphenylene ether (product name: XYRON^{™} S203A, manufactured by Asahi Kasei Engineering Plastics), about 0.5 grams of tetramethyl ammonium chloride, and about 8.25 grams of tetramethyl bisphenol A were added into the reaction container and heated to 90°C to dissolve.

Then, about 3.7 grams of about 75 wt% benzoyl peroxide was added dropwise (e.g., in at least four portions) over a time length of about 60 minutes. Throughout this process, continuous stirring was maintained, and a constant temperature was maintained (at about 70°C or higher, such as about 70°C to 90°C).

After completing the aforementioned dropwise addition, it was stirred continuously at the constant temperature (about 70°C to 90°C) for about 3 hours to react.

After the reaction, alkaline washing was carried out on the reacted solution with an appropriate amount of 20 wt% sodium hydroxide aqueous solution (e.g., the total volume ratio of the reacted solution to the used sodium hydroxide aqueous solution may be about 1:1 to 1:5) at a constant temperature (about 70 °C) for about 1 hour. Afterwards, the aqueous layer was removed.

Then, tetrahydrofuran was added to the organic solvent layer after removing the aqueous layer, so as to recrystallize and remove the unreacted or non-reactive polyphenylene ether at or below about 15°C. Afterwards, methanol was added to precipitate the resin, followed by a drying process.

The number average molecular weight of the resin in <Example 1> may be about 2,772 g/mole, the molecular weight distribution may be about 1.47, the resin hydroxyl equivalent weight may be about 1260g/eq, and the number of hydroxyl groups per molecule (i.e., number average molecular weight/resin hydroxyl equivalent weight) may be about 2.2. In addition, the ratio of the total weight of the polymer monomer with a molecular weight of more than 20,000 g/mole to the total weight of the resin was about 0.5 wt%.

### <Example 2>

About 600 grams of toluene, about 100 grams of commercially available polyphenylene ether (product name: XYRON^{™} S202A, manufactured by Asahi Kasei Engineering Plastics), about 0.5 grams of benzyltrimethylammonium chloride, and about 11.6 grams of tetramethyl biphenol were added into the reaction container and heated to about 100°C to dissolve.

Then, about 5.2 grams of about 75 wt% benzoyl peroxide was added dropwise (e.g., in at least eight portions) over a time length of about 120 minutes. Throughout this process, continuous stirring was maintained, and a constant temperature was maintained (at about 70°C or higher, such as about 70°C to 100°C).

After completing the aforementioned dropwise addition, it was stirred continuously at the constant temperature (about 70°C to 100^{°}C) for about 3 hours to react.

After the reaction, alkaline washing was carried out on the reacted solution with an appropriate amount of sodium methoxide at a constant temperature (about 50°C or higher, such as about 50°C to 70°C) for about 1 hour. After that, water was added for washing, and then the aqueous layer was removed.

Then, methyl ethyl ketone was added to the organic solvent layer after removing the aqueous layer, so as to recrystallize and remove the unreacted or non-reactive polyphenylene ether at or below about 15°C. Afterwards, methanol was added to precipitate the resin, followed by a drying process.

The number average molecular weight of the resin in <Example 2> may be about 2,320 g/mole, the molecular weight distribution may be about 1.43, the resin hydroxyl equivalent weight may be about 960g/eq, and the number of hydroxyl groups per molecule may be about 2.4. In addition, the ratio of the total weight of the polymer monomer with a molecular weight of more than 20,000 g/mole to the total weight of the resin was about 0.3 wt%.

### <Example 3>

About 600 grams of xylene, about 100 grams of commercially available polyphenylene ether (product name: StarAir ^{®} LXR-035, manufactured by China National BlueStar (Group) Co, Ltd.), and about 20 grams of 1,1,2,2-Tetrakis(4-hydroxyphenyl)ethane were added into the reaction container and heated to about 110°C to dissolve.

Then, about 10 grams of about 75 wt% benzoyl peroxide was added dropwise (e.g., in at least twelve portions) over a time length of about 240 minutes. Throughout this process, continuous stirring was maintained, and a constant temperature was maintained (at about 70°C or higher, such as about 70°C to 110°C).

After completing the aforementioned dropwise addition, it was stirred continuously at the constant temperature (about 70°C to 110°C) for about 3 hours to react.

After the reaction, alkaline washing was carried out on the reacted solution with an appropriate amount of sodium methoxide at a constant temperature (about 50°C or higher, such as about 50°C to 70°C) for about 2 hours. After that, water was added for washing, and then the aqueous layer was removed.

Then, cyclohexanone was added to the organic solvent layer after removing the aqueous layer, so as to recrystallize and remove the unreacted or non-reactive polyphenylene ether at or below about 4°C. Afterwards, methanol was added to precipitate the resin, followed by a drying process.

The number average molecular weight of the resin in <Example 3> may be about 2,124 g/mole, the molecular weight distribution may be about 1.50, the resin hydroxyl equivalent weight may be about 566g/eq, and the number of hydroxyl groups per molecule may be about 3.75. In addition, the ratio of the total weight of the polymer monomer with a molecular weight of more than 20,000 g/mole to the total weight of the resin was about 0.9 wt%.

### <Example 4>

About 600 grams of toluene, about 100 grams of commercially available polyphenylene ether (product name: XYRON^{™} S203A), about 0.5 grams of tetramethyl ammonium chloride, and about 19 grams of tetramethyl biphenol were added into the reaction container and heated to 90°C to dissolve.

Then, about 6 grams of about 75 wt% benzoyl peroxide was added dropwise (e.g., in at least six portions) over a time length of about 120 minutes. Throughout this process, continuous stirring was maintained, and a constant temperature was maintained (at about 70°C or higher, such as about 70°C to 90^{°}C).

After completing the aforementioned dropwise addition, it was stirred continuously at the constant temperature (about 70°C to 90^{°}C) for about 3 hours to react.

After the reaction, alkaline washing was carried out on the reacted solution with an appropriate amount of 8 wt% sodium bicarbonate aqueous solution at a constant temperature (about 70° C) for about 1 hour. Afterwards, the aqueous layer was removed.

Then, methyl isobutyl ketone was added to the organic solvent layer after removing the aqueous layer, so as to recrystallize and remove the unreacted or non-reactive polyphenylene ether at or below about 25°C. Afterwards, methanol was added to precipitate the resin, followed by a drying process.

The number average molecular weight of the resin in <Example 4> may be about 1,750 g/mole, the molecular weight distribution may be about 1.60, the resin hydroxyl equivalent weight may be about 670g/eq, and the number of hydroxyl groups per molecule may be about 2.60. In addition, the ratio of the total weight of the polymer monomer with a molecular weight of more than 20,000 g/mole to the total weight of the resin was about 0.1 wt%.

### <Example 5>

About 600 grams of toluene, about 100 grams of commercially available polyphenylene ether (product name: XYRON^{™} S202A), about 0.5 grams of tetramethyl ammonium chloride, and about 42 grams of tetramethyl biphenol were added into the reaction container and heated to 80°C to dissolve.

Then, about 10 grams of about 75 wt% benzoyl peroxide was added dropwise (e.g., in at least six portions) over a time length of about 120 minutes. Throughout this process, continuous stirring was maintained, and a constant temperature was maintained (at about 70°C or higher, such as about 70°C to 80^{°}C).

After completing the aforementioned dropwise addition, it was stirred continuously at the constant temperature (about 70°C to 80^{°}C) for about 3 hours to react.

After the reaction, alkaline washing was carried out on the reacted solution with an appropriate amount of 49.5 wt% sodium hydroxide aqueous solution at a constant temperature (about 70° C) for about 1 hour. Afterwards, the aqueous layer was removed.

Then, cyclohexanone was added to the organic solvent layer after removing the aqueous layer, so as to recrystallize and remove the unreacted or non-reactive polyphenylene ether at or below about 25 °C. Afterwards, methanol was added to precipitate the resin, followed by a drying process.

The number average molecular weight of the resin in <Example 5> may be about 1,260 g/mole, the molecular weight distribution may be about 1.5, the resin hydroxyl equivalent weight may be about 360 g/eq, and the number of hydroxyl groups per molecule may be about 3.50. In addition, the ratio of the total weight of the polymer monomer with a molecular weight of more than 20,000 g/mole to the total weight of the resin was about 0.05 wt%.

### <Comparative example 1>

About 600 grams of toluene, about 100 grams of commercially available polyphenylene ether (product name: XYRON^{™} S202A), about 0.5 grams of tetramethyl ammonium chloride, and about 8 grams of tetramethyl biphenol were added into the reaction container and heated to 80°C to dissolve.

Then, about 19 grams of about 75 wt% benzoyl peroxide was added dropwise (e.g., in at least six portions) over a time length of about 120 minutes. Throughout this process, continuous stirring was maintained, and a constant temperature was maintained (at about 70°C or higher, such as about 70°C to 80^{°}C).

After completing the aforementioned dropwise addition, it was stirred continuously at the constant temperature (about 70°C to 80^{°}C) for about 3 hours to react.

After the reaction, the reacted solution was directly washed with water at a constant temperature (about 70° C.). Afterwards, the aqueous layer was removed.

Afterwards, methanol was added to the organic solvent layer after removing the aqueous layer to precipitate the resin, followed by a drying process.

The number average molecular weight of the resin in <Comparative example 1> may be about 1,815 g/mole, the molecular weight distribution may be about 4.50, the resin hydroxyl equivalent weight may be about 1,215 g/eq, and the number of hydroxyl groups per molecule may be about 1.5. In addition, the ratio of the total weight of the polymer monomer with a molecular weight of more than 20,000 g/mole to the total weight of the resin was about 6.5 wt%.

### <Comparative example 2>

About 600 grams of toluene, about 100 grams of commercially available polyphenylene ether (product name: XYRON^{™} S202A), about 0.5 grams of tetramethyl ammonium chloride, and about 6 grams of tetramethyl biphenol were added into the reaction container and heated to 80°C to dissolve.

Then, about 30 grams of about 75 wt% benzoyl peroxide was added dropwise (e.g., in at least six portions) over a time length of about 120 minutes. Throughout this process, continuous stirring was maintained, and a constant temperature was maintained (at about 70°C or higher, such as about 70°C to 80^{°}C).

After completing the aforementioned dropwise addition, it was stirred continuously at the constant temperature (about 70°C to 80^{°}C) for about 3 hours to react.

After the reaction, the reacted solution was directly washed with water at a constant temperature (about 70° C.). Afterwards, the aqueous layer was removed.

Afterwards, methanol was added to the organic solvent layer after removing the aqueous layer to precipitate the resin, followed by a drying process.

The number average molecular weight of the resin in <Comparative example 2> may be about 1,292 g/mole, the molecular weight distribution may be about 3.8, the resin hydroxyl equivalent weight may be about 685 g/eq, and the number of hydroxyl groups per molecule may be about 1.9. In addition, the ratio of the total weight of the polymer monomer with a molecular weight of more than 20,000 g/mole to the total weight of the resin was about 4.2 wt%.

The corresponding adjustments and corresponding results of <Example 1> to <Example 5> and <Comparative example 1> to <Comparative example 5> are shown in [Table 1].

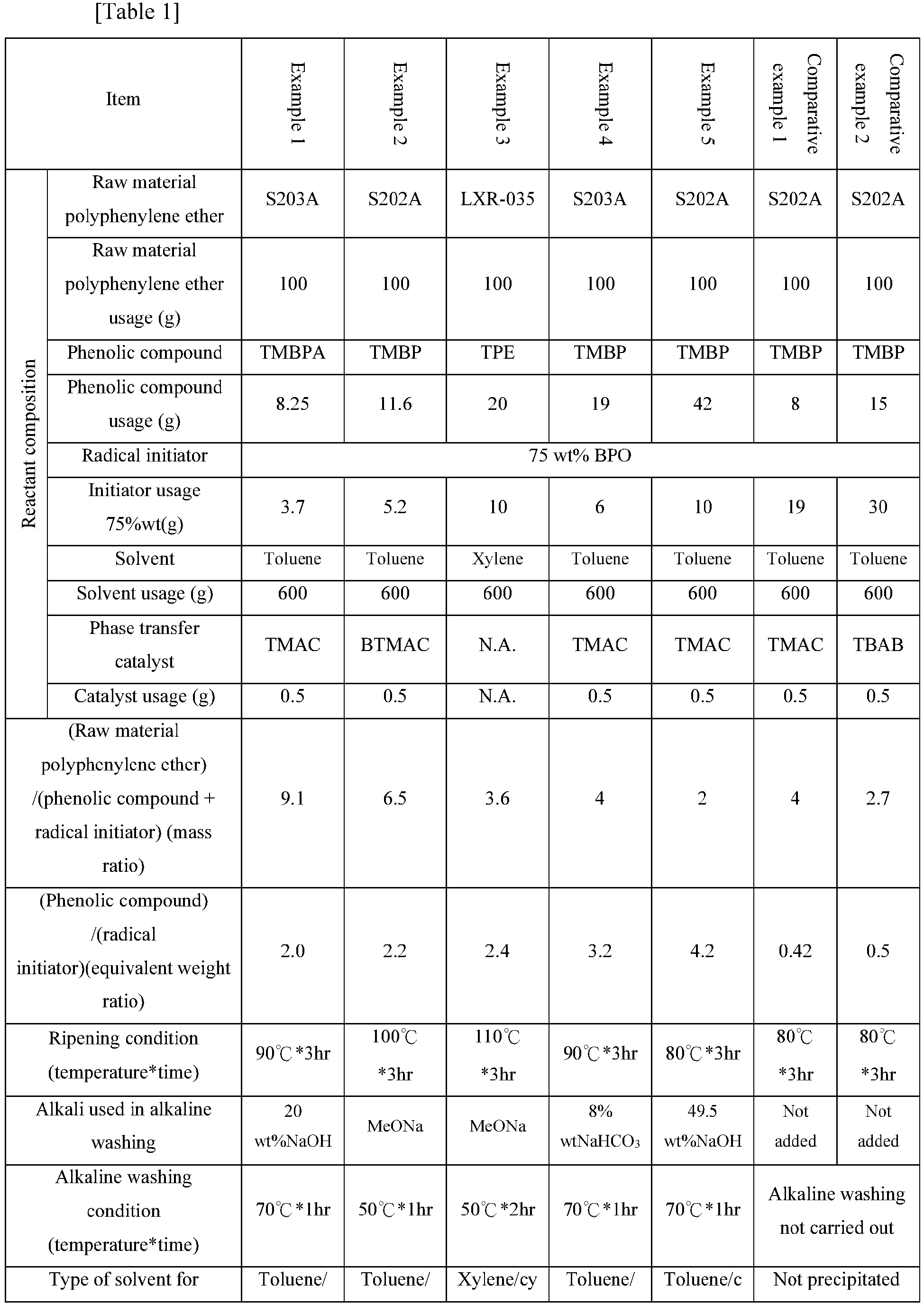

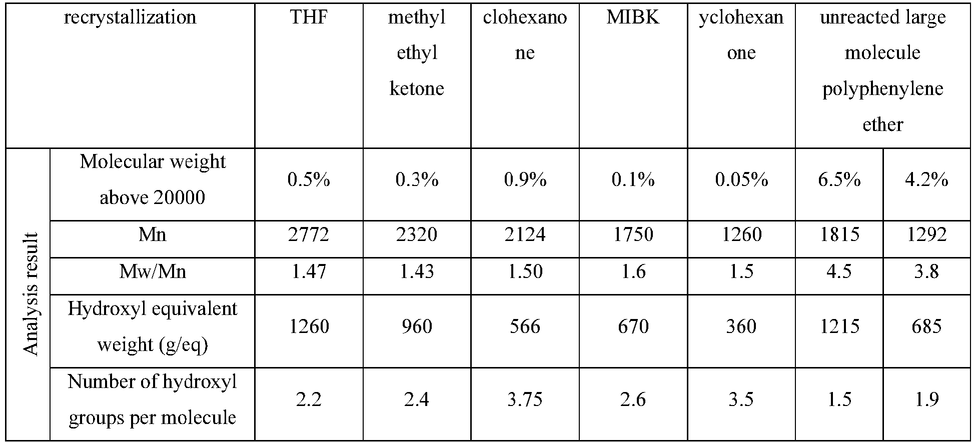

### <Evaluation method>

Specific molecular weight distribution ratio: The corresponding distribution ratio of a specific molecular weight may be estimated by integrating the corresponding molecular weight distribution curve. Taking the distribution ratio with a molecular weight above 20,000 g/mol as an example, it may be obtained by dividing the curve integral value with a molecular weight above 20,000 g/mol by all the curve integral values of the molecular weight distribution.

Number average molecular weight (Mn): The prepared modified polyphenylene ether resin was dissolved in tetrahydrofuran (THF) to prepare a solution to be tested with a concentration of 1 weight %. Next, the number average molecular weight of the solution to be tested was measured by gel permeation chromatography (GPC).

Weight average molecular weight (Mw): The prepared modified polyphenylene ether resin was dissolved in tetrahydrofuran (THF) to prepare a solution to be tested with a concentration of 1 weight %. Next, the weight average molecular weight of the solution to be tested was measured by gel permeation chromatography (GPC).

Polydispersity index (PDI): The polydispersity index was calculated by dividing the measured weight average molecular weight by the measured number average molecular weight (i.e., Mw/Mn). The smaller the PDI, the more concentrated the distribution of molecular weight. Under the condition that the initial reactants, the catalyst, and their corresponding amounts were the same or similar, the smaller the PDI, the smaller the possibility of corresponding side reactions, which makes the distribution of molecular weight more concentrated. Thus, a concentrated molecular weight distribution (i.e., a smaller the PDI) may be expressed as more uniform in functional group, morphology, and/or structure, and may be called more uniform in reaction/synthesis. Moreover, a concentrated molecular weight distribution (i.e., a smaller PDI) indicates that the relative ratio of byproducts from side reactions (e.g., larger polymer molecules formed through re-polymerization) may be reduced. Consequently, in terms of the application of the product, the subsequent processing or application may be more stable, leading to improved product quality or higher yield during further processing.

Hydroxyl equivalent weight: Determined by commonly used standards (e.g., but not limited to ISO 4629-2:2016, ASTM E222-10, GB/T 12008.3, and CNS 6681).

The number of hydroxyl groups per molecule: Converted from the corresponding hydroxyl equivalent weight and the corresponding molecular weight (e.g., number average molecular weight).

As shown in [Table 1], compared with <Comparative example 1> and <Comparative example 2>, the polydispersity index (PDI; i.e., Mw/Mn) of the modified polyphenylene ether resin in <Example 1> to <Example 5> (which may be the modified polyphenylene ether resin in one embodiment of the disclosure) may be lower. Thus, subsequent processing or application may be more stable, so that the subsequent processed product may have better quality or better yield.

As shown in [Table 1], compared with <Example 1> to <Example 5>, the number average molecular weight of the resins in <Comparative example 1> and <Comparative example 2> (i.e., not the modified polyphenylene ether resin in one embodiment of the disclosure, and may be referred to as a non-modified polyphenylene ether resin) were equivalent to that of <Example 1> to <Example 5>. However, the ratio of the molecule with a molecular weight above 20,000 g/mol was high. This may be due to the fact that the corresponding alkaline washing step was not carried out, and it was difficult or impossible to separate out and remove the large molecule polyphenylene ether. Thus, the resins of <Comparative example 1> and <Comparative example 2> may be poor in subsequent applicability.

As shown in [Table 1], compared with <Comparative example 1> and <Comparative example 2>, the modified polyphenylene ether resin in <Example 1> to <Example 5> (which may be the modified polyphenylene ether resin in one embodiment of the disclosure) possessed a greater number of hydroxyl groups per molecule. This may be due to the manufacturing method of the modified polyphenylene ether resin in one embodiment of the disclosure included the corresponding alkaline washing step, which may increase the number of hydroxyl groups per molecule.

### <Example and comparative example applied to copper clad laminate>

The resin varnish composition was prepared by mixing according to the formulation composition ratio as shown in [Table 2], and the copper clad laminate was prepared using the aforementioned method.

In <Example 6> to <Example 10>, the modified polyphenylene ether used may be the modified polyphenylene ether obtained in <Example 1> to <Example 5> respectively. In <Comparative example 3>, the polyphenylene ether used may be a kind of resin commonly used in the production of general copper clad laminates (e.g., SA-9000 resin manufactured by Sabic Corporation; i.e., not the modified polyphenylene ether resin in one embodiment of the disclosure, and may be referred to as a non-modified polyphenylene ether resin). In <Comparative example 4>, the polyphenylene ether used may be the resin in <Comparative example 1> (i.e., not the modified polyphenylene ether resin in one embodiment of the disclosure, and may be referred to as a non-modified polyphenylene ether resin).

In <Example 6> to <Example 10> and <Comparative example 3> and <Comparative example 4>, the cross-linking agent used was triallyl isocyanurate sold by Mitsubishi Chemical Corporation.

In <Example 6> to <Example 10> and <Comparative example 3> and <Comparative example 4>, the filler used was silicon dioxide filler, marketed under the trade name 525ARI series.

In <Example 6> to <Example 10> and <Comparative example 3> and <Comparative example 4>, the cross-linking promoter used was a peroxide formulation cross-linking promoter from Arkema S.A. (French), marketed under the trade name Luperox^{®} LuF series.

In <Example 6> to <Example 10> and <Comparative example 3> and <Comparative example 4>, the flame retardant used was a phosphorous flame retardant from Otsuka Chemical Co., Ltd. in Japan, marketed under the trade name SPB-100.

In <Example 6> to <Example 10> and <Comparative example 3> and <Comparative example 4>, about 53 parts by weight (referred to as 53 wt%) of the resin composition (including either the aforementioned modified polyphenylene ether resin or the non-modified polyphenylene ether resin, the cross-linking agent, the filler, the cross-linking promoter, and the flame retardant) were mixed with about 47 parts by weight (referred to as 47 wt%) of solvent (toluene/methyl ethyl ketone co-solvent) to form the corresponding resin varnish composition used for preparing the copper clad laminate.

### <Example 6>

The resin of <Example 1> was olefinated with methacrylic anhydride.

Specifically, about 100 grams of toluene, about 100 grams of the resin of <Example 1>, about 14.7 grams of methacrylic anhydride, and about 8.9 grams of 4-(Dimethylamino)pyridine (DMAP) were added into the reaction container. The reaction container was filled with dry nitrogen, heated to about 85°C, and reacted for about 4 hours.

After the reaction, methanol was added to precipitate and clean the resin.

The resin, after being cleaned and dried, exhibited an acid number of about 1.44 mgKOH/g, an OH number of the residual hydroxyl group of about 0.5 mgKOH/g, a number average molecular weight of about 2,840 g/mol, and a molecular weight distribution of about 1.45.

The resin varnish composition was prepared by mixing according to the formulation composition ratio as shown in [Table 2], and the copper clad laminate was prepared using the aforementioned method. And, the evaluation was made.

Specifically, in <Example 6>, with the total weight of the resin composition being 100 wt%, the resin composition consisted of about 40 parts by weight (referred to as 40 wt%) of the olefinated resin of <Example 1>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Example 6> for preparing the copper clad laminate.

### <Example 7>

The resin of <Example 2> was olefinated with methacrylic anhydride.

Specifically, about 100 grams of toluene, about 100 grams of the resin of <Example 2>, about 18.7 grams of methacrylic anhydride, and about 11.5 grams of 4-(Dimethylamino)pyridine (DMAP) were added into the reaction container. The reaction container was filled with dry nitrogen, heated to about 90^{°}C, and reacted for about 5 hours.

After the reaction, methanol was added to precipitate and clean the resin.

The resin, after being cleaned and dried, exhibited an acid number of about 1.34 mgKOH/g, an OH number of the residual hydroxyl group of about 0.1 mg KOH/g, a number average molecular weight of about 2,460 g/mole, and a molecular weight distribution of about 1.41.

The resin varnish composition was prepared by mixing according to the formulation composition ratio as shown in [Table 2], and the copper clad laminate was prepared using the same method as <Example 6>. And, the evaluation was made.

Specifically, in <Example 7>, with the total weight of the resin composition being 100 wt%, the resin composition consisted of about 40 parts by weight (referred to as 40 wt%) of the olefinated resin of <Example 2>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Example 7> for preparing the copper clad laminate.

### <Example 8>

The resin of <Example 3> was olefinated with methacrylic anhydride.

Specifically, about 100 grams of toluene, about 100 grams of the resin of <Example 3>, about 27.2 grams of methacrylic anhydride, and about 16.6 grams of 4-(Dimethylamino)pyridine (DMAP) were added into the reaction container. The reaction container was filled with dry nitrogen, heated to about 95°C, and reacted for about 6 hours.

After the reaction, methanol was added to precipitate and clean the resin.

The resin, after being cleaned and dried, exhibited an acid number of about 1.2 mgKOH/g, an OH number of the residual hydroxyl group of about 0.7mgKOH/g measured by titration, a number average molecular weight of about 2,392 g/mole, and a molecular weight distribution of about 1.43.

The resin varnish composition was prepared by mixing according to the formulation composition ratio as shown in [Table 2], and the copper clad laminate was prepared using the same method as <Example 6>. And, the evaluation was made.

Specifically, in <Example 8>, with the total weight of the resin composition being 100 wt%, the resin composition consisted of about 40 parts by weight (referred to as 40 wt%) of the olefinated resin of <Example 3>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Example 8> for preparing the copper clad laminate.

### <Example 9>

The resin of <Example 4> was olefinated with methacrylic anhydride.

Specifically, about 100 grams of toluene, about 100 grams of the resin of <Example 4>, about 27.6 grams of methacrylic anhydride, and about 15.5 grams of 4-(Dimethylamino)pyridine (DMAP) were added into the reaction container. The reaction container was filled with dry nitrogen, heated to about 85°C, and reacted for about 6 hours.

After the reaction, methanol was added to precipitate and clean the resin.

The resin, after being cleaned and dried, exhibited an acid number of about 1.2 mgKOH/g, an OH number of the residual hydroxyl group of about 0.2 mgKOH/g measured by titration, a number average molecular weight of about 1,955 g/mole, and a molecular weight distribution of about 1.45.

The resin varnish composition was prepared by mixing according to the formulation composition ratio as shown in [Table 2], and the copper clad laminate was prepared using the same method as <Example 6>. And, the evaluation was made.

Specifically, in <Example 9>, with the total weight of the resin composition being 100 wt%, the resin composition consisted of about 40 parts by weight (referred to as 40 wt%) of the olefinated resin of <Example 4>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Example 9> for preparing the copper clad laminate.

### <Example 10>

The resin of <Example 5> was olefinated with methacrylic anhydride.

Specifically, about 100 grams of toluene, about 100 grams of the resin of <Example 5>, about 51.3 grams of methacrylic anhydride, and about 27.1 grams of 4-(Dimethylamino)pyridine (DMAP) were added into the reaction container. The reaction container was filled with dry nitrogen, heated to about 85°C, and reacted for about 4 hours.

After the reaction, methanol was added to precipitate and clean the resin.

The resin, after being cleaned and dried, exhibited an acid number of about 1.5 mgKOH/g, an OH number of the residual hydroxyl group of about 0.1 mgKOH/g measured by titration, a number average molecular weight of about 1,417 g/mole, and a molecular weight distribution of about 1.45.

The resin varnish composition was prepared by mixing according to the formulation composition ratio as shown in [Table 2], and the copper clad laminate was prepared using the same method as <Example 6>. And, the evaluation was made.

Specifically, in <Example 10>, with the total weight of the resin composition being 100 wt%, the resin composition consisted of about 40 parts by weight (referred to as 40 wt%) of the olefinated resin of <Example 5>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Example 10> for preparing the copper clad laminate.

### <Comparative example 3>

The SA-9000 resin (manufactured by Sabic Corporation) was olefinated with methacrylic anhydride.

Specifically, about 100 grams of toluene, about 100 grams of the resin of <Comparative example 1>, about 15.2 grams of methacrylic anhydride, and about 8.5 grams of 4-(Dimethylamino)pyridine (DMAP) were added into the reaction container. The reaction container was filled with dry nitrogen, heated to about 85°C, and reacted for about 4 hours.

After the reaction, methanol was added to precipitate and clean the resin. Subsequently, centrifugation was carried out using toluene as the solvent to remove insoluble products (which may include the corresponding resin).

The product (which may include the corresponding resin), after being dried, exhibited an acid number of about 2.2 mgKOH/g, an OH number of the residual hydroxyl group of about 0.1mg KOH/g measured by titration, a number average molecular weight of about 1452 g/mole, and a molecular weight distribution of about 1.8.

The resin varnish composition was prepared by mixing according to the formulation composition ratio as shown in [Table 2], and the copper clad laminate was prepared using the same method as <Example 6>. And, the evaluation was made.

Specifically, in <Example 3>, with the total weight of the resin composition being 100 wt%, the resin composition consisted of about 40 parts by weight (referred to as 40 wt%) of the olefinated SA-9000 resin, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Comparative example 3> for preparing the copper clad laminate.

### <Comparative example 4>

The resin of <Comparative example 1> was olefinated with methacrylic anhydride.

Specifically, about 100 grams of toluene, about 100 grams of the resin of <Comparative example 4>, about 15.2 grams of methacrylic anhydride, and about 8.5 grams of 4-(Dimethylamino)pyridine (DMAP) were added into the reaction container. The reaction container was filled with dry nitrogen, heated to about 85°C, and reacted for about 4 hours.

After the reaction, methanol was added to precipitate and clean the resin. Subsequently, centrifugation was carried out using toluene as the solvent to remove insoluble products (which may include the corresponding resin).

The product (which may include the corresponding resin), after being dried, exhibited an acid number of about 2.2 mgKOH/g, an OH number of the residual hydroxyl group of about 0.1mg KOH/g measured by titration, a number average molecular weight of about 1452 g/mole, and a molecular weight distribution of about 1.8.

The resin varnish composition was prepared by mixing according to the formulation composition ratio as shown in [Table 2], and the copper clad laminate was prepared using the same method as <Example 6>. And, the evaluation was made.

Specifically, in <Comparative example 4>, with the total weight of the resin composition being 100 wt%, the resin composition consisted of about 40 parts by weight (referred to as 40 wt%) of the olefinated resin of <Comparative example 1>, about 15 parts by weight (referred to as 15 wt%) of the cross-linking agent, about 10 parts by weight (referred to as 10 wt%) of the filler, about 1 part by weight (referred to as 1 wt%) of the cross-linking promoter, and about 10 parts by weight (referred to as 10wt%) of the flame retardant. Furthermore, about 53 parts by weight (referred to as 53 wt%) of the resin composition were mixed with about 47 parts by weight (referred to as 47 wt%) of solvent (toluene/methyl ethyl ketone co-solvent), serving as the resin varnish composition used in <Comparative example 3> for preparing the copper clad laminate.

### <Example and comparative example applied to copper clad laminate>

The resin varnish composition was prepared by mixing according to the formulation composition ratio as shown in [Table 2], and the copper clad laminate was prepared using the aforementioned method.

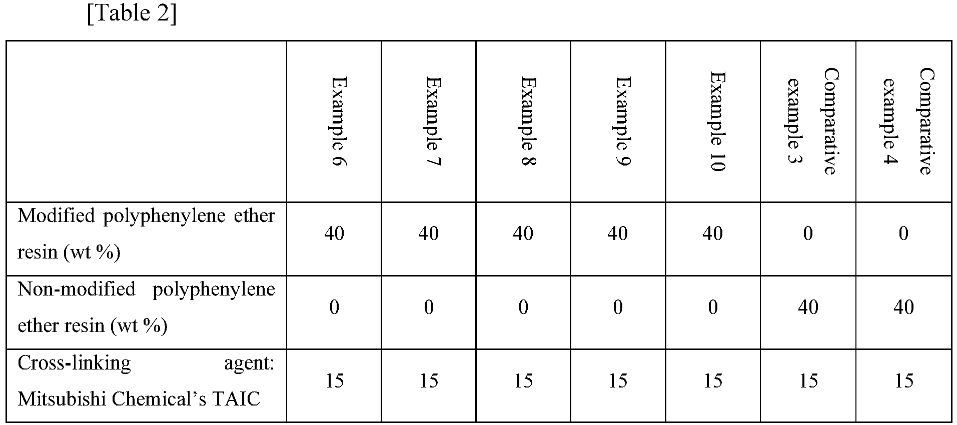

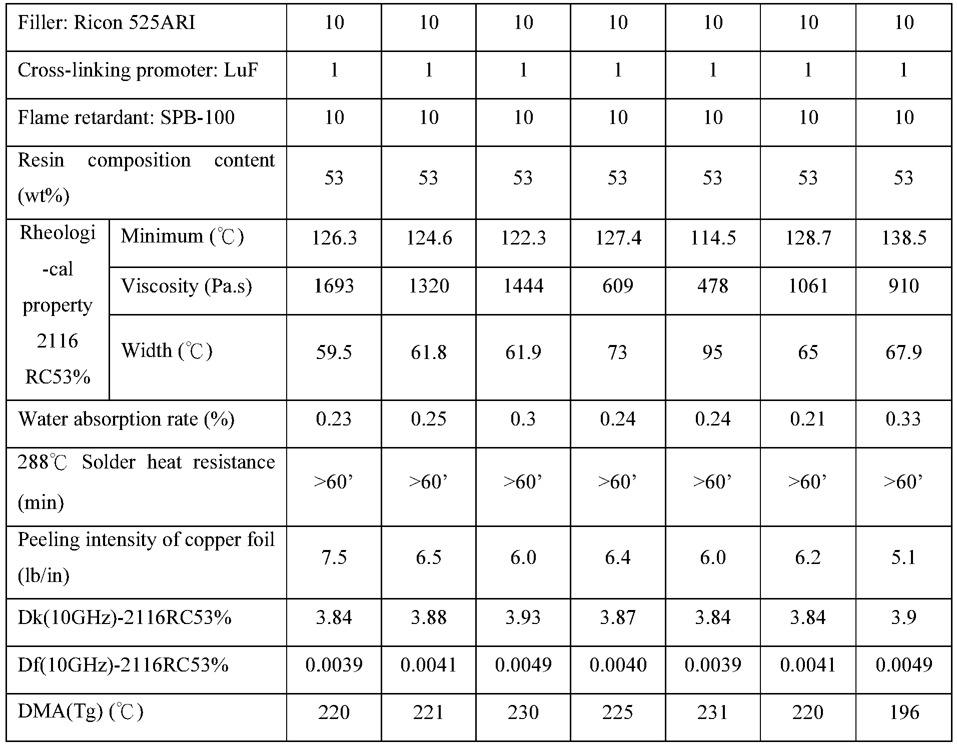

### <Evaluation method>

### a. Dynamic viscosity test

Using a prepreg of 2116 fiberglass cloth with 53% resin content (RC) (referred to as 2116RC53%), the corresponding evaluation was conducted as follows. Method: The prepreg was rubbed to generate powder, and about 0.45 grams of the powder was placed in a commercially available rheometer (e.g., those manufactured by TA Instruments, Inc. or HITACHI) to measure the dynamic viscosity. Measurement conditions: The heating rate was about 2.5°C/minute, the measurement temperature range was from 50°C to 180°C, and the lowest viscosity value (unit: Pa s) was recorded, along with the minimum temperature having the lowest viscosity value (referred to as "Minimum"; unit: °C) and the corresponding temperature range (referred to as "Width"; unit: °C). The temperature range (referred to as "Width"; unit: °C) represents the corresponding temperature range where the viscosity of the resin composition is below 10000 Pa·s. By comparing the temperature ranges, differences in the operability of the corresponding resin may be indicated. For instance, a larger temperature range suggests better operability.

### b. Water absorption rate

A 5cm × 5cm square test piece was placed in an oven at about 105°C for an appropriate period (e.g., about 2 hours), and then the test piece was transferred to a pressure cooker. The conditions inside the pressure cooker was about 2atm×120°C . After about 120 minutes in the pressure cooker, the water absorption rate was calculated by the following formula: the weight difference of the test piece before and after being placed in the pressure cooker÷initial weight of the test piece×100%

### c. Heat resistance

The testing method was to immerse the aforementioned pressure cooker test piece into a solder furnace at 288±5°C for observation. The time required for the delamination of the test piece was recorded. Generally, if there is no delamination observed within 60 minutes, it indicates a successful passing of the heat resistance test.

### d. Peeling intensity

Similar to the aforementioned method, the peeling intensity of the film made of the resin composition of the above formulation was measured by a universal stretching machine according to IPC-TM-650, Method 2.4.8.

### e. Dielectric constant (Dk)

The dielectric constant test: The testing method was to bake a square copper clad laminate test piece of about 5cm×5cm from which the copper foil has been removed in an oven at about 105°C for about 2 hours. The thickness was measured with a thickness tester, and then the test piece was clamped into an impedance analyzer (Agilent E4991A) to measure the dielectric constant Dk data of 3 points and calculate the average value.

### f. Dissipation factor (Df)

The dissipation factor test: The testing method was to bake a square copper clad laminate test piece of about 5cm×5cm from which the copper foil has been removed in an oven at about 105°C for about 2 hours. The thickness was measured with a thickness tester, and then the test piece was clamped into an impedance analyzer (Agilent E4991A) to measure the dissipation factor Df data of 3 points and calculate the average value.

### g. Glass transition temperature (Tg)

Similar to the aforementioned method, the glass transition temperature (Tg) of the films produced by the resin composition of the above formulation was measured by a dynamic mechanical analyzer (DMA).

### <Evaluation result>

According to the experimental results in [Table 2], the preparation of the copper clad laminate may be carried out by the modified polyphenylene ether resin in one embodiment of the disclosure. Moreover, the electrical properties and/or glass transition temperature of the prepared copper clad laminate are equal to or better than those of traditional resins (e.g., polyphenylene ether resin used in the manufacture of general copper clad laminate).

In addition, Dk and Df may still meet the dielectric level of general copper clad laminates (e.g., very Low Loss level with Df of 0.0030 to 0.0065).

In addition, compared to using traditional resin (e.g., polyphenylene ether resin used in the manufacture of general copper clad laminates), other characteristics may be equivalent or within the corresponding standard specifications.

Based on the above, compared to commercially available resins used in copper clad laminate manufacturing, the modified polyphenylene ether resin in one embodiment of the disclosure offers a simpler preparation process. Furthermore, the modified polyphenylene ether resin in one embodiment of the disclosure is suitable for the manufacturing of copper clad laminates, and/or the copper clad laminates manufactured by adopting the same meets common specifications.

Furthermore, by adjusting the preparation method and/or the corresponding ratio of the modified polyphenylene ether resin in one embodiment of the disclosure, the corresponding resin composition to be applied to the copper clad laminate may meet customized specifications. For example, the glass transition temperature may be changed correspondingly by changing the corresponding number of hydroxyl groups (e.g., the number of hydroxyl groups per molecule and the glass transition temperature basically have a positive relationship). For example, the smaller the molecular weight, the higher the mobility may be. For another example, the higher the molecular weight, the higher the corresponding peeling intensity may be.

### [Industrial applicability]

In addition, the modified polyphenylene ether resin in the aforementioned embodiment of the disclosure may be directly or indirectly applied to copper clad laminates, and may be further processed into other electronic components or electronic products (e.g., circuit boards or copper clad laminates) for livelihood, industry, or suitable applications.

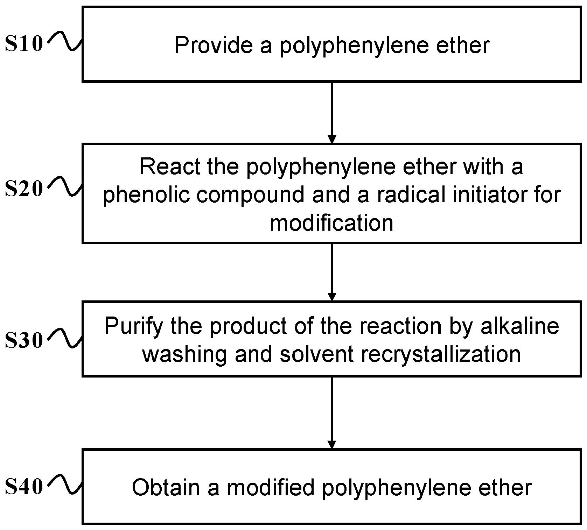

## Claims

1. A preparation method of a modified polyphenylene ether resin, comprising:
providing an unmodified polyphenylene ether;
reacting the unmodified polyphenylene ether with a phenolic compound and a radical initiator to obtain a corresponding product; and
purifying the product by alkaline washing and solvent recrystallization to obtain the modified polyphenylene ether resin.

2. The preparation method of the modified polyphenylene ether resin according to claim 1, wherein the unmodified polyphenylene ether comprises poly(2,6-dimethyl-1,4-phenylene ether).

3. The preparation method of the modified polyphenylene ether resin according to claim 1, wherein an equivalent weight of the radical initiator is about 0.05 times to about 2 times a phenolic equivalent weight of the phenolic compound.

4. The preparation method of the modified polyphenylene ether resin according to claim 1, further comprising adding catalyst when reacting the unmodified polyphenylene ether with the phenolic compound and the radical initiator.

5. A modified polyphenylene ether resin, having a structure represented by the following [Formula 1]: 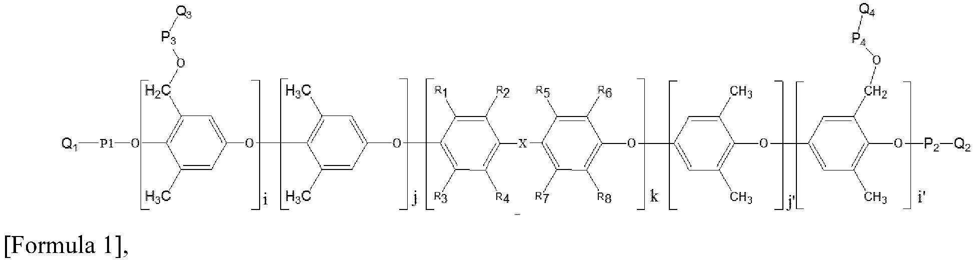 wherein in [Formula 1]:
k is an integer greater than or equal to 0;
i, i', j, and j' are identical or different from each other; i and j are integers from 0 to 200, respectively; and i' and j' are integers from 1 to 200, respectively;
a value of i+i'+j+j'+k is between 2 and 400;
Ri to R₈ are identical or different from each other, and are respectively selected from a hydrogen group or an alkyl group with C1 to C6;
P₁ to P₄ are identical or different from each other, and are respectively selected from a single bond or a ketone group;
Q₁ to Q₄ are identical or different from each other, and are respectively selected from a benzene ring group, a styryl group, a phenylethynyl group, an ethynyl group, a vinyl group, a methyl vinyl group, a naphthalene ring group, or hydrogen; and
X is a linking group selected from a single bond or the following:

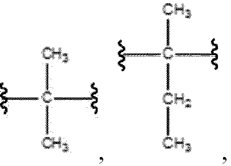

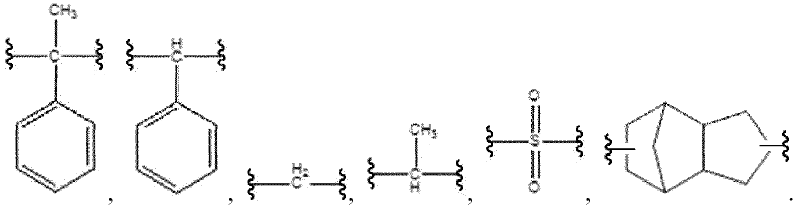

6. The modified polyphenylene ether resin according to claim 5, prepared by a preparation method comprising:
providing an unmodified polyphenylene ether;
reacting the unmodified polyphenylene ether with a phenolic compound and a radical initiator to obtain a corresponding product; and
purifying the product by alkaline washing and solvent recrystallization to obtain the modified polyphenylene ether resin.

7. The modified polyphenylene ether resin according to claim 5, comprising the following properties:
a number average molecular weight between 500 g/mole and 4000 g/mole;
a molecular weight distribution less than or equal to 2.5; and
a total weight of a composition with a molecular weight greater than 20,000 g/mole accounts for less than 1.5 wt%, based on the total weight of the modified polyphenylene ether resin.

8. The modified polyphenylene ether resin according to claim 5, having an average number of hydroxyl groups per molecule greater than or equal to 2.2.

9. A resin composition, comprising:
a modified polyphenylene ether resin, having a structure represented by the following [Formula 1]: 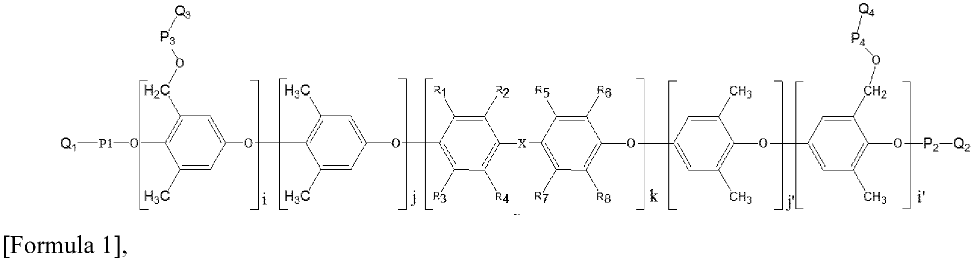 wherein in [Formula 1]:
k is an integer greater than or equal to 0;
i, i', j, and j' are identical or different from each other; i and j are integers from 0 to 200, respectively; and i' and j' are integers from 1 to 200, respectively;
a value of i+i'+j+j'+k is between 2 and 400;
Ri to R₈ are identical or different from each other, and are respectively selected from a hydrogen group or an alkyl group with C1 to C6;
P₁ to P₄ are identical or different from each other, and are respectively selected from a single bond or a ketone group;
Q₁ to Q₄ are identical or different from each other, and are respectively selected from a benzene ring group, a styryl group, a phenylethynyl group, an ethynyl group, a vinyl group, a methyl vinyl group, a naphthalene ring group, or hydrogen; and
X is a linking group selected from a single bond or the following:

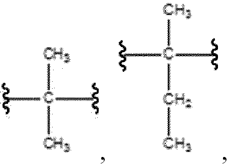

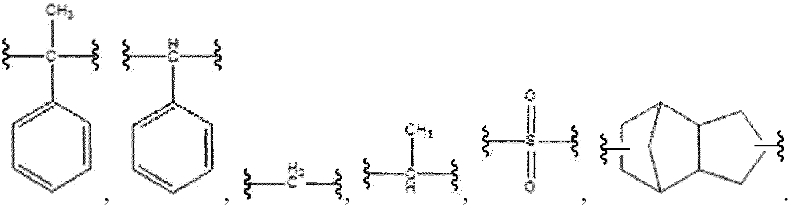

10. An electronic component, comprising a film layer formed from a resin composition comprising:
a modified polyphenylene ether resin, having a structure represented by the following [Formula 1]: 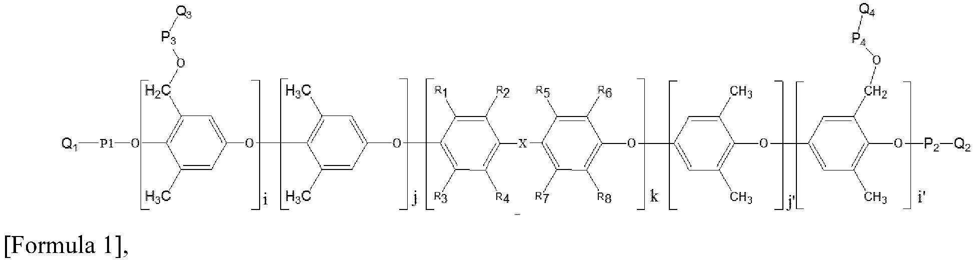 wherein in [Formula 1]:
k is an integer greater than or equal to 0;
i, i', j, and j' are identical or different from each other; i and j are integers from 0 to 200, respectively; and i' and j' are integers from 1 to 200, respectively;
a value of i+i'+j+j'+k is between 2 and 400;
Ri to R₈ are identical or different from each other, and are respectively selected from a hydrogen group or an alkyl group with C1 to C6;
P₁ to P₄ are identical or different from each other, and are respectively selected from a single bond or a ketone group;
Q₁ to Q₄ are identical or different from each other, and are respectively selected from a benzene ring group, a styryl group, a phenylethynyl group, an ethynyl group, a vinyl group, a methyl vinyl group, a naphthalene ring group, or hydrogen; and
X is a linking group selected from a single bond or the following:
